(19) Europäisches Patentamt
European Patent Office
Office européen des brevets

(11) **EP 0 815 469 B1**

(12) **EUROPÄISCHE PATENTSCHRIFT**

(45) Veröffentlichungstag und Bekanntmachung des Hinweises auf die Patenterteilung:
**06.11.2002 Patentblatt 2002/45**

(51) Int Cl.⁷: **G01S 13/02**, H03H 9/42

(86) Internationale Anmeldenummer:
**PCT/EP97/00256**

(21) Anmeldenummer: **97901567.4**

(22) Anmeldetag: **20.01.1997**

(87) Internationale Veröffentlichungsnummer:
**WO 97/026555 (24.07.1997 Gazette 1997/32)**

(54) **VERFAHREN ZUM DURCHFÜHREN EINER BERÜHRUNGSLOSEN FERNABFRAGE**

PROCESS FOR CONDUCTING A CONTACT-FREE REMOTE INQUIRY

PROCEDE POUR EFFECTUER UNE INTERROGATION A DISTANCE SANS CONTACT

(84) Benannte Vertragsstaaten:
**CH DE FR LI SE**

(30) Priorität: **18.01.1996 CH 13596**

(43) Veröffentlichungstag der Anmeldung:
**07.01.1998 Patentblatt 1998/02**

(73) Patentinhaber: HERA Rotterdam B.V.
**3062 MA Rotterdam (NL)**

(72) Erfinder: **STIERLIN, Roland**
**CH-5034 Suhr (CH)**

(74) Vertreter: **VOSSIUS & PARTNER**
**Siebertstrasse 4**
**81675 München (DE)**

(56) Entgegenhaltungen:
**WO-A-90/15343          WO-A-93/13495**
**US-A- 4 734 698**

• **ELEKTRONIK, Bd. 33, Nr. 18, 7.September 1984, MUNCHEN DE, Seiten 87-93, XP002031162 STOCKER H: "Akustische Oberflächenwellen-Bauelemente"**

**Beschreibung**

Die Erfindung betrifft ein Verfahren zum Durchführen einer berührungslosen Fernabfrage, wobei

a) eine Abfragestation ein Abfragesignal an einen mobilen Transponder aussendet und
b) dieses Abfragesignal im Transponder mit einer Antenne empfangen, durch Einkoppeln in mehrere parallele Codierkanäle in ein codiertes Antwortsignal umgewandelt und dann an die Abfragestation zurückgesendet wird.

Weiter betrifft die Erfindung eine Anordnung zur Durchführung des Verfahrens, einen Transponder für eine solche Anordnung und ein SAW-Element geeignet für einen Transponder.

Ein Verfahren der eingangs genannten Art ist z. B. aus dem US-Patent 4,737,790 (Skele et al./X-Cyte Inc.) bekannt. Mit einer Abfragestation können dabei passive SAW-Transponder (sog. SAW-tags) identifiziert werden. Die Transponder verfügen über ein geeignet verpacktes SAW-Element (SAW = surface acoustic wave) aus piezoelektrischem Material und geeignete Antennen zum Empfangen und Abstrahlen von elektromagnetischen Wellen im Bereich von 905-925 MHz. Das SAW-Element modifiziert das empfangene Abfragesignal in Amplitude und Phase. Das Abfragesignal ist ein sog. Chirp-Signal, dessen Frequenz sägezahnartig im Bereich von 905-925 MHz variiert. Das SAW-Element verfügt über 16 verschiedene Ausbreitungspfade (akustische Codierkanäle). Ihre Signallaufzeiten sind für alle SAW-Elemente des Systems so festgelegt, dass sie sich jeweils um ein vorgegebenes Zeitintervall DeltaT unterscheiden. Die über verschiedene Pfade laufenden Signale weisen somit eine konstante (d. h. für alle tags gleiche) zeitliche Stufung auf. Beim Mischen des Abfragesignals mit den Antwortsignalen wird in der Abfragestation eine vorgegebene Anzahl von im voraus bekannten Differenzfrequenzen erzeugt.

Die Differenzfrequenzsignale entsprechen den Schwebungen zwischen dem Abfrage- und dem Antwortsignal. Sie werden von entsprechend abgestimmten Filtern verarbeitet. Da in jedem Ausbreitungspfad des SAW-Elements Dämpfungs- bzw. Phasenschiebeelemente entsprechend dem transponderspezifischen Code eingebaut sind, lassen sich aus den Phasen bzw. Amplituden der Differenzfrequenzsignale die transponderspezifischen Codeinformationen gewinnen.

Ein Problem bei solchen und ähnlichen Fernidentifikationssystemen besteht darin, das Nutzsignal (Antwortsignal) möglichst gut von Störsignalen zu trennen. Störsignale entstehen dabei sowohl ausserhalb des Transponders (z. B. durch Reflexionen des Abfragesignals an metallischen Gegenständen) als auch innerhalb desselben (z. B. Mehrfachreflexionen zwischen Transducer und Reflektoren in den akustischen Kanälen).

Ein für die Kommerzialisierung von SAW-tags wichtiger Aspekt ist deren kostengünstige Produktion. Ein für die Stückkosten wichtiger Faktor ist dabei die Fläche des verwendeten SAW-Elementes. Je kleiner diese ist, desto preiswerter wird der tag. Die bekannten SAW-tags vermögen diesbezüglich noch nicht zu befriedigen, auch wenn es aus US 4. 734. 698 bereits bekannt ist, eine gemeinsame, (auf Zeiterhöhende Signalstrecke im Empfangspfad eines SAW-tags an Zuordnen.

Aufgabe der Erfindung ist es, ein Verfahren der eingangs genannten Art anzugeben, das sowohl eine wirksame Eliminierung von Störsignalen als auch eine kostengünstige Realisierung mittels SAW-Elementen erlaubt.

Gemäss der Erfindung besteht die Lösung darin, dass Abfrage-bzw. Antwortsignal im Transponder durch eine sowohl im Empfangs- als auch im Sendepfad des Transponders wirksame, gemeinsame laufzeiterhöhende Signalstrecke geführt wird, um das Antwortsignal von störenden Umgebungs-Reflexionen des Abfragesignals besser trennen zu können.

Im Rahmen der Erfindung wird für eine Mehrzahl von Codierkanälen eine einzige gemeinsame laufzeiterhöhende Signalstrekke (Verzögerungsstrecke) verwendet. Man ersetzt also insbesondere die nach dem Stand der Technik in jedem einzelnen Codierkanal eines SAW-tags vorhandene Verzögerungsstrecke und führt bewusst eine gemeinsame zusätzliche Verzögerungsstrecke ein. Dadurch können die nach- bzw. vorgeschalteten Codierkanäle auf eine minimale Länge gebracht werden, ohne die Gesamtlaufzeit des Abfrage-bzw. Antwortsignals im Transponder zu verkürzen. Entsprechend kann die für den SAW-Chip erforderliche Fläche erheblich verringert werden.

In den-Codierkanälen wird vorzugsweise eine Laufzeitcodierung durchgeführt. Das Abfragesignal kann in den verschiedenen Codierkanälen entsprechend einem transponderspezifischen Code unterschiedlich verzögert werden. jeder Transponder ist in diesem Fall letztlich durch die zeitliche Position der im Abfragesignal enthaltenen Echos (bzw. der örtlichen Position der Reflektoren) identifizierbar (Positionscodierung). Möglich ist aber auch eine Pulsform-, Amplituden- oder Phasencodierung ähnlich wie im eingangs zitierten Stand der Technik (vgl. z. B. US-4,737,790). Denkbar ist auch eine Frequenzcodierung (FSK-Prinzip).

Gewisse Codierkanäle können aber auch zur Erzeugung eines Referenzsignals verwendet werden. Das Antwortsignal enthält dann auch Signalkomponenten, deren Codierung der Abfragestation von vornherein bekannt sind und die nicht zur Identifizierung, sondern zur Kalibrierung (Gesamtlaufzeit, Temperatureffekte etc.) des Systems oder zur Messung einer physikalischen Grösse (insbesondere der Temperatur) am Ort des Transponders dienen können. Für die identifizierende einerseits und zu Kalibrier- und/oder Messzwecken dienende Codierung andererseits können unterschiedliche laufzeiterhöhende Signalstrecken verwendet werden. Denkbar ist auch, dass nur ein Teil der Codierkanäle an der gemeinsamen laufzeiterhöhenden Signalstrecke angehängt ist.

Die Erfindung eignet sich nicht nur für die Codierung und Identifizierung von Objekten, sondern auch für die Temperaturmessung. Mindestens einer der Codierkanäle (welcher nicht zur Identifikation dient) kann zur Temperaturmessung am Ort des Transponders verwendet werden. Eine solche Temperaturmessung beruht auf der Temperaturabhängigkeit der Signallaufzeit bei vorgegebener Reflektorposition. Im Prinzip wird die Temperatur des SAW-Elements durch Messung des Laufzeitunterschieds von mindestens zwei Antwortsignalkomponenten in verschiedenen Codepositionen bestimmt.

Eine Anordnung zur Durchführung einer erfindungsgemässen berührungslosen Fernabfrage verfügt über eine Abfragestation zum Aussenden eines Abfragesignals und zum Empfangen und Auswerten eines Antwortsignals, mindestens einen mobilen Transponder mit einer Antenne zum Empfangen des Abfragesignals und/oder Abstrahlen des Antwortsignals und eine Codiereinheit mit mehreren parallelen Codierkanälen zum Umwandeln des Abfragesignals in ein Antwortsignal durch Codierung. Im Sinne der Erfindung ist vor bzw. nach der mindestens einen Codiereinheit eine allen entsprechenden Codierkanälen gemeinsame laufzeiterhöhende Signalstrecke angeordnet.

In der Praxis verfügt eine erfindungsgemässe Anordnung über eine Vielzahl von mobilen Transpondern bzw. SAW-tags (je nach Anwendung z. B. mehrere zehn oder mehrere zehntausend). Auch können an mehreren Orten Abfragestationen (entsprechend den jeweiligen Systemanforderungen) vorgesehen sein.

Vorzugsweise ist die von den Codierkanälen getrennte Signalstrecke auf einem SAW-Element ausgebildet. Am besten sind Signalstrecke und Codierkanäle auf dem gleichen SAW-Element (Chip) integriert. Es ist aber durchaus möglich, für die Signalstrecke einen eigenen SAW-Chip vorzusehen. Im übrigen ist nicht ausgeschlossen, dass die Codierkanäle nicht auf einem SAW-Element, sondern in anderer Weise ausgebildet sind (elektronische Schaltung). Es können auch mehrere unterschiedlich laufzeiterhöhende Signalstrecken vorhanden sein.

Die Codierkanäle können zur Erzeugung einer Laufzeitcodierung ausgebildet sein. D. h. die Länge der genannten Kanäle entspricht einem transponderspezifischen Code. Je kürzer die Codierkanäle sind, desto kleiner ist die benötigte Chipfläche. Man wird deshalb bestrebt sein, die Kanäle auf die zur Implementation der Codierung erforderliche Minimallänge zu beschränken.

Die Signalstrecke befindet sich zwischen der Antenne und der Codiereinheit. Die mit Reflektoren ausgerüsteten Codierkanäle reflektieren das Abfragesignal zu individuellen Zeitpunkten. Die Signalstrecke wird also sowohl vom Abfrage- als auch vom Antwortsignal durchlaufen. Denkbar ist auch ein Transponder, bei welchem die laufzeiterhöhende Signalstrecke nur einmal durchlaufen wird (z. B. wenn die Codiereinheit nicht im "Reflexionsbetrieb", sondern im "Durchlaufbetrieb" arbeitet). Für SAW-Chipanwendungen ist aber der doppelte Durchlauf der laufzeiterhöhenden Signalstrecke durchaus von Vorteil, da bei vorgegebener Verzögerungszeit die für die Signalstrecke benötigte Chiplänge durch den Mehrfachdurchlauf reduziert wird ("Mehrfachbenutzung" der Signalstrecke).

Wenn Signalstrecke und Codiereinheit auf demselben SAW-Element integriert sind, dann können die entsprechenden Strukturen durch Transducer (Fingerelektrodenstrukturen), 90°-Reflektoren (z. B. Kopplung von zwei parallelen Kanälen durch zwei aufeinander ausgerichtete 90°-Reflektoren) oder durch RMSC-Strukturen (RMSC = Reversing multistrip coupler) gekoppelt werden. Im Unterschied zu den Ausführungsformen mit Transducern (bei welchen parasitäre Reflexionen des Signals bei -15 bis -20 dB auftreten können) sind die 90°-Reflektoren und die RMSC-Strukturen weitgehend frei von störenden internen Reflexionen.

Bei der Kopplung mit Transducern ergeben sich sowohl störende interne Reflexionen am Transducer der gemeinsamen. Verzögerungsstrecken als auch störende Mehrfachreflexionen in den Codierkanälen. Die störenden internen Reflexionen oder deren Einflüsse können aber durch geeignete Ausführung der Transducer und/oder geeignete Wahl der Kanallängen minimiert werden.

In aller Regel werden Signalstrecke und Codierkanäle auf einem SAW-Chip durch parallele akustische Kanäle gebildet. Die Codierkanäle können durch ein- oder beidseitig abstrahlende Transducerstrukturen angeregt werden. Im erstgenannten Fall sind nur auf der einen, im zweitgenannten auf beiden Seiten codespezifisch positionierte Reflektoren vorgesehen. Bei beidseitig abstrahlenden Transducern speist im Prinzip jeder Transducer zwei Codierkanäle. Bei z. B. acht Codierkanälen können zur weiteren Minimierung der erforderlichen Chipfläche des SAW-Elements mit einem ersten Transducer z. B. der längste und der kürzeste, mit einem zweiten der zweitlängste und der zweitkürzeste Codierkanal etc. gespeist werden. Die Reflektoren können z. B. in fest vorgegebenen Positionen angeordnet sein, so dass die Laufzeitcodierung durch die Transducerposition bestimmt ist. Selbstverständlich ist es auch möglich, die Transducer in geometrisch fest vorgegebenen Positionen auf dem SAW-Element anzuordnen und dann die Reflektoren codespezifisch zu positionieren. Welche dieser Varianten gewählt wird, hängt vor allem von herstellungstechnischen umständen und Möglichkeiten ab (z. B. Präzision, Reproduzierbarkeit bei der Positionierung der Mikrostrukturen und Herstellungskosten).

Da die schwächste Komponente des Antwortsignals die Lesedistanz bestimmt, sind Massnahmen vorteilhaft, die die Dämpfung in den verschiedenen Codierkanälen auf gleiches Niveau bringen. Dies ist von besonderer Bedeutung im Frequenzbereich oberhalb 1 GHz, da dort die Dämpfung von SAW-Signalen erheblich grösser ist als im Frequenzbereich unter 1 GHz. So können z. B. in Codierkanälen mit grösseren Laufzeiten mehr Elektrodenfinger im Reflektor vorgesehen sein als in Kanälen mit kleineren Laufzeiten, so dass ein verhältnismässig grösserer Anteil der Oberflächenwelle reflektiert wird und damit die grösseren Dämpfungsverluste bei längeren Laufzeiten kompensiert werden können. Auch kann die Apertur der Kanäle entsprechend der Länge festgelegt sein, so dass sich laufzeitbedingte Dämpfung einerseits und aperturbedingte Dämpfung andererseits in den verschiedenen Kanälen (nach Möglichkeit) ausgleichen.

Als Substrat für ein SAW-Element eignet sich z. B. 128-LiNbO$_3$ oder YZ-LiNbO$_3$.

Weitere bevorzugte Ausführungsformen und Merkmalskombinationen ergeben sich aus der nachfolgenden Detailbeschreibung und der Gesamtheit der Patentansprüche.

Die zur Erläuterung der Ausführungsbeispiele verwendeten Zeichnungen zeigen:

Fig. 1    Eine schematische Darstellung einer Anordnung zur Durchführung einer berührungslosen Fernidentifikation;

Fig. 2a, b    Zeitdiagramme zur Erläuterung der bevorzugten Laufzeitcodierung;

Fig. 3    eine schematische Darstellung einer SAW-Einheit mit integrierter Verzögerungsstrecke und beidseitig abstrahlenden Transducern;

Fig. 4    eine Alternative zur Ausführungsform gemäss Fig. 2 mit einseitig abstrahlenden Transducern;

Fig. 5    eine schematische Darstellung einer SAW-Einheit mit 90°-Reflektoren;

Fig. 6    eine schematische Darstellung einer einzelnen RMSC-Struktur;

Fig. 7    eine schematische Darstellung einer Ausführungsform mit RMSC-Kopplung zwischen laufzeiterhöhender Signalstrecke und Codierkanälen.

Grundsätzlich sind in den Zeichnungen gleiche Teile mit gleichen Bezugszeichen versehen.

Bevor auf den Kern der Erfindung eingegangen wird, soll zunächst das Gesamtsystem kurz erläutert werden.

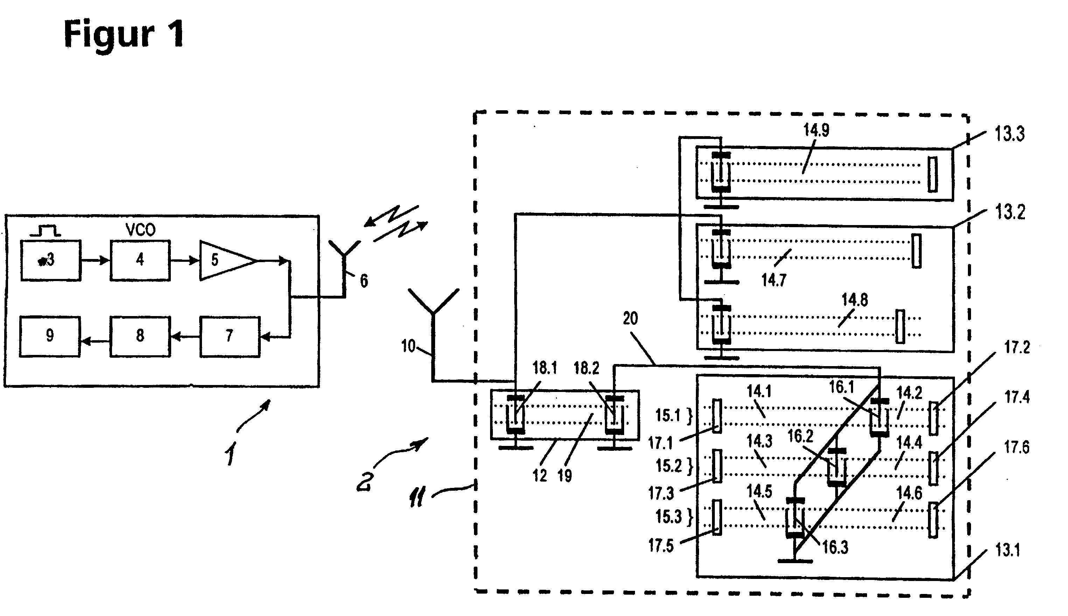

Fig. 1 zeigt ein grobes Blockschaltbild einer Abfragestation 1 und eines Transponders 2. Die z. B. ortsfeste Abfragestation 1 sendet ständig Abfragesignale aus und wertet eintreffende Antwortsignale von mobilen, in der Nähe befindlichen Transpondern 2 aus. Beim Transponder 2 handelt es sich um ein passives Element mit einer (vorzugsweise integrierten) Antenne 10 und einer SAW-Einheit 11. Er ist z. B. als flaches Plättchen oder als Karte ausgebildet und an dem zu identifizierenden Gegenstand .als Markierung. (Label) angebracht.

Die Abfragestation verfügt über einen Pulsformer 3, welcher geeignet geformte Pulse einer mittleren Dauer von z. B. 5-10 ns erzeugt. Er steuert den Trägersignalgenerator 4 (VCO) an, welcher ein frequenzstabilisiertes Signal von z. B. 2.45 GHz erzeugt. Das resultierende Abfragesignal wird mit einem Verstärker 5 verstärkt und über eine Antenne 6 abgestrahlt.

Nach Verstreichen eines günstig gewählten minimalen Zeitintervalls T$_0$ trifft das Antwortsignal des Transponders 2 ein. Dieses wird einem Demodulator 7 und dann einer Diskriminator/Decodierschaltung 8 zugeführt. Der Demodulator 7 demoduliert die Signalkomponenten, während die Diskriminator/Decodierschaltung 8 die relative zeitliche Verzögerung der Signalkomponenten detektiert und entsprechend dem Zeitraster decodiert. Der Code wird z. B. in einem Speicher 9 (welcher z. B. durch einen nicht dargestellten externen Computer lesbar ist) zwischengespeichert.

Im Transponder 2 wird das über die Antenne 10 empfangene Abfragesignal über eine erfindungsgemässe laufzeiterhöhende Signalstrecke 12 zu einer Codiereinheit 13.1 geführt. Letztere verfügt über eine Mehrzahl von Codierkanälen. Die Funktion der Codierkanäle soll anhand einer bevorzugten Signalcodierung erläutert werden.

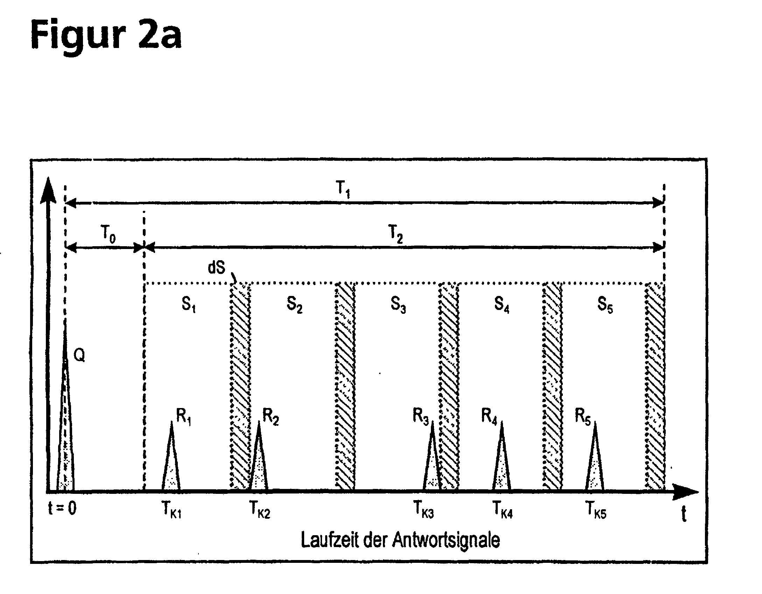

Fig. 2a zeigt schematisch eine mögliche Signalkonstellation (auf der Abszisse ist die Zeit t aufgetragen). Zum Zeitpunkt t = 0 wird ein z. B. pulsförmiges Abfragesignal Q mit einer Trägerfrequenz von z. B. 2.45 GHz ausgesendet. Die Pulsdauer beträgt vorzugsweise weniger als 20 ns (z. B. 5 ns). Ein in Reichweite befindlicher Transponder empfängt das Abfragesignal Q und wandelt es mit Hilfe einer SAW-Einheit in ein Antwortsignal um, das im vorliegenden Beispiel fünf Signalkomponenten R$_1$ .... R$_5$ aufweist. Die SAW-Einheit ist dabei so gestaltet, dass bis zum Empfang der ersten Signalkomponente R$_1$ ein Zeitintervall T$_0$ verstreicht, das vorzugsweise mindestens halb so gross wie das Zeitintervall T$_1$ ist. Auf diese Weise kann das Nutzsignal wirkungsvoll von reflexionsbedingten Umgebungsstörsignalen befreit werden (externe Reflexionen).

Das Zeitintervall T$_2$ = T$_1$ - T$_0$, dessen Länge für das System (welches in der Regel eine Vielzahl von Transpondern umfasst) fest vorgegeben ist, ist aufgeteilt in eine Vielzahl von (im vorliegenden Beispiel fünf) Zeitfenstern S$_1$, ..., S$_5$, die alle gleich gross sind (z. B. 125 ns). Alle Transponder des Systems sind so ausgeführt, dass in jedem der fünf Zeitfenster S$_1$, ..., S$_5$ genau

eine Signalkomponente $R_1$, ..., $R_5$ auftritt.

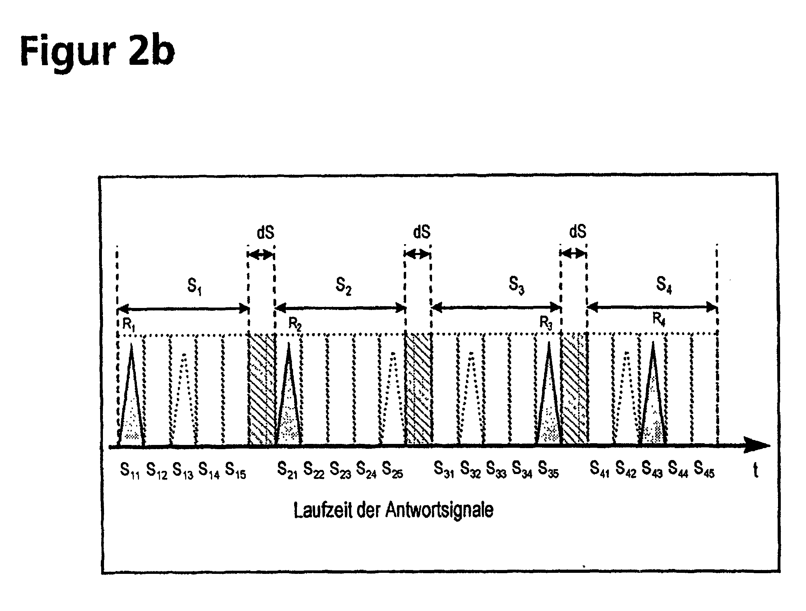

Die Zeitfenster $S_1$, ..., $S_5$ können gemäss einer bevorzugten Ausführungsform durch einen zusätzlichen Zeitschlitz dS getrennt werden (z. B. dS = 25 ns). Damit kann der minimal mögliche Zeitabstand zwischen zwei Signalkomponenten in benachbarten Zeitfenstern nach Bedarf zusätzlich verlängert werden (vgl. auch Fig. 2b).

Gemäss der bevorzugten Signalcodierung ist nun die Position einer Signalkomponente $R_1$, ..., $R_5$ innerhalb des entsprechenden Zeitfensters $S_1$, ..., $S_5$ von der im Transponder realisierten Codierung abhängig. Die Abfragestation muss daher zur Identifizierung die zeitlichen Positionen $T_{k1}$, ..., $T_{k5}$ des Transponders k bestimmen.

Fig. 2b veranschaulicht die Decodierung des Antwprtsignals. Alle Zeitfenster $S_1$, ..., $S_5$ (das letzte Zeitfenster ist in Fig. 2b nicht mehr dargestellt) sind in eine vorgegebene Anzahl von z. B. fünf Zeitschlitzen $s_{11}$, ..., $s_{15}$, $s_{21}$, ..., $s_{25}$, $s_{31}$, ... etc. einer Dauer von z. B. je 25 ns aufgeteilt. (Die Länge eines Zeitfensters $S_1$, ..., $S_5$ beträgt in diesem Fall also 125 ns.) Nach dem bekannten Prinzip der matched filter-Technik werden die Signalkomponenten $R_1$, ..., $R_5$ detektiert und dem jeweiligen Zeitschlitz (hier z. B. $s_{11}$, $s_{21}$, $s_{35}$, $s_{43}$) zugeordnet. Die Kombination der Zeitpositionen ergibt den transponderspezifischen Code.

In Fig. 2b sind gestrichelt andere mögliche Positionen von Signalkomponenten angedeutet (Zeitschlitze $s_{13}$, $s_{25}$, $s_{32}$, $s_{42}$ etc.), wie sie bei einem anderen Transponder vorliegen könnten. Diese Verteilung der Signalkomponenten würde natürlich zu einem anderen Code führen. Offensichtlich können mit fünf Zeitfenstern zu je fünf Zeitschlitzen $5^5$ = 3125 Codes unterschieden werden. In der Praxis wird man die Zahl der Fenster oder der Zeitschlitze erhöhen (bei zehn Fenstern zu fünf Schlitzen stehen bereits $5^{10}$ d. h. ca. $10^7$ Codes zur Verfügung). Je kleiner die Breite eines Schlitzes, desto grösser die Anforderungen an die Fertigungsgenauigkeit der SAW-Einheit und desto schwieriger die Detektion. Es ist natürlich nicht erforderliche dass die Antwortsignalkomponenten vollständig innerhalb eines Zeitschlitzes liegen. Es ist durchaus denkbar, dass sie beidseits aus einem Zeitschlitz herauslappen, wobei jedoch dann zumindest der "Energieschwerpunkt" hinreichend genau lokalisierbar sein muss.

Die Länge des Zeitintervalls $T_0$ hängt natürlich nicht nur vom Transponder selbst, sondern auch von seinem Abstand zur Abfragestation ab.

Anstelle von pulsförmigen Abfragesignalen können bevorzugt sog. Chirp-Signale (Signale mit sägezahnförmigem Frequenzverlauf) verwendet werden. Das Antwortsignal besteht dann aus unterschiedlich gegeneinander verschobenen (bzw. verzögerten), überlagerten Chirp-Signalen. Die Differenzfrequenzen entsprechen den unterschiedlichen Signalverzögerungen. Sie können mit an sich bekannten Filtern extrahiert werden.

Die als SAW-Element ausgebildete Codiereinheit 13.1 verfügt im vorliegenden Beispiel über sechs Codierkanäle 14.1 bis 14.6, welche je eine Antwortsignalkomponente mit codespezifischer Verzögerung erzeugen. Physikalisch sind die Codierkanäle 14.1 bis 14.6 in drei akustischen Kanälen 15.1 bis 15.3 verwirklicht. In jedem akustischen Kanal 15.1 bis 15.3 sind eine Transducerelektrode 16.1 bis 16.3 und zwei Reflektoren 17.1 und 17.2 resp. 17.3 und 17.4 resp. 17.5 und 17.6 vorgesehen. Die Transducerelektroden 16.1, 16.2, 16.3 sind derart zwischen den zwei entsprechenden Reflektoren 17.1, 17.2 resp. 17.3, 17.4 resp. 17.5, 17.6 angeordnet, dass die sechs erwähnten Codierkanäle mit codespezifischer Länge gebildet werden.

Zwischen Antenne 10 und Codiereinheit 13.1 ist die laufzeiterhöhende Signalstrecke 12. Sie ist ebenfalls auf einem SAW-Element implementiert und stellt sicher, dass das Antwortsignal die bereits erwähnte minimale Laufzeitverzögerung $T_0$ hat. Die minimale Laufzeitverzögerung $T_0$ wird bewusst nicht in den einzelnen Codierkanälen 14.1 bis 14.6, sondern in einem vor- bzw. nachgeschalteten separaten Element bzw. Signalpfad erzeugt. Wenn nämlich die erforderliche minimale Signalverzögerung in jedem einzelnen Codierkanal (quasi zusammen mit der Codierung) eingeführt wird, dann wird insgesamt viel mehr Substratoberfläche benötigt als bei der erfindungsgemässen Ausführung.

Es ist nicht zwingend, dass die ganze Verzögerung $T_0$ (initial delay) in der getrennten Signalstrecke 12 realisiert ist. Flächenmässige Einsparungen können sich z. B. auch bei 50-80%iger Auslagerung von $T_0$ in die Signalstrecke 12 ergeben.

Das von den Antenne 10 empfangene Abfragesignal wird also über eine erste Transducerelektrode 18.1 in einen akustischen Kanal 19 eines SAW-Element eingekoppelt, dort um eine Zeit $t_{delay}$ = L/V (wobei L die Distanz zwischen den Transducerelektroden 18.1, 18.2 und V die Ausbreitungsgeschwindigkeit des Signals im akustischen Kanal 19 bezeichnet) verzögert, dann über die Transducerelektrode 18.2 ausgekoppelt und über eine elektrische Leitung 20 zur Codiereinheit 13.1 geführt. In dieser wird das z. B. pulsförmige Abfragesignal entsprechend der jeweiligen Länge der Codierkanäle 14.1 bis 14.6 verzögert reflektiert und dann - in Form eines Antwortsignals - ein zweites Mal in der Signalstrecke 12 um $t_{delay}$ verzögert. Die gesamte Signalverzögerung durch die Signalstrecke 12 ist also $t_{init}$ = 2L/V. Um z. B. $t_{init}$ = 1 ms zu erzeugen, werden auf einem 128-$LiNbO_3$-Substrat L = 1990 um, d. h. etwa 2 mm benötigt. Vorzugsweise ist $t_{init}$ etwa gleich gross oder geringfügig (z. B. 10%) kleiner als $T_0$.

In Fig. 1 ist im Sinne einer Option eine Erweiterung der SAW-Einheit 11 gezeigt, die darin besteht, dass neben der Codiereinheit 13.1 weitere Codiereinheiten 13.2, 13.3 mit Codierkanälen 14.7, 14.8 bzw. 14.9 vorgesehen sind. Diese weiteren Codiereinheiten 13.2, 13.3 sind direkt an der Antenne 10 angeschlossen und benutzen daher die gemeinsame laufzeiterhöhende Signalstrecke 12 nicht. Die Codiereinheit 13.3 kann z. B. als Referenzkanal ausgebildet sein, welcher bei allen Transpondern gleich ist. Im Antwortsignal kann auf diese Weise eine Referenzsignalkomponente erzeugt werden, welche für alle Transponder des Systems gleich ist. Die parallel zur Codiereinheit 13.3 betriebene Codiereinheit 13.2 kann z. B. eine gruppenspezifische Codierung erzeugen.

Den Codiereinheiten 13.2, 13.3 kann z. B. auch eine eigene laufzeiterhöhende Signalstrecke eingeschoben werden. D. h. es können in einem Transponder bzw. einer SAW-Einheit 11 gewünschtenfalls auch mehrere unterschiedlich lange laufzeiterhöhende Signalstrecken vorgesehen sein.

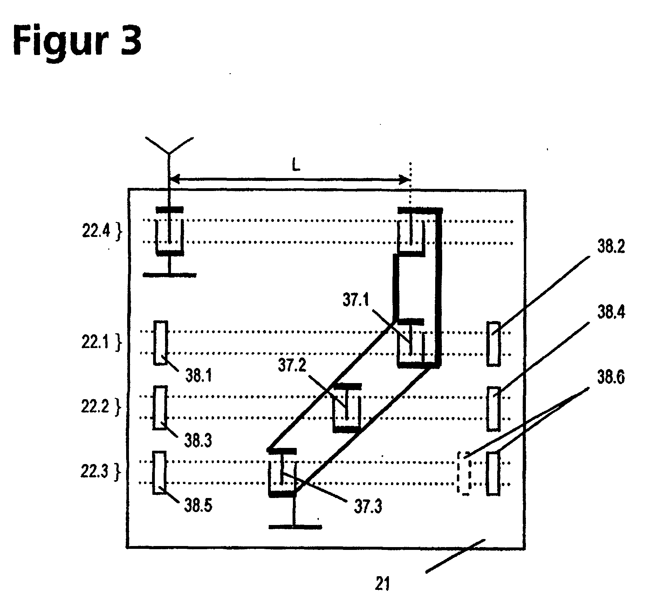

Fig. 3 zeigt eine bevorzugte Ausführungsform der Erfindung, bei welcher auf einem einzigen SAW-Chip 21 neben den (beispielsweise drei) zur Codierung dienenden akustischen Kanälen 22.1 bis 22.3 ein zusätzlicher Kanal 22.4 als laufzeiterhöhende Signalstrecke vorgesehen ist. Die vier akustischen Kanäle 22.1, ..., 22.4 sind so angeordnet und bemessen, dass eine möglichst kleine und möglichst quadratnahe Fläche erforderlich ist. In einer bevorzugten Ausführungsform wird die gemeinsame laufzeiterhöhende Signalstrecke mindestens etwa gleich lang sein wie der längste Codierkanal.

Die Transducer 37.1 bis 37.3 sind auf einer bezüglich der Chipfläche diagonalen Linie auf die Kanäle 22.1 bis 22.3 verteilt. Bei der Codierung durch Positionieren der Reflektoren 38.1 bis 38.6 ist die Position der Transducer 37.1 bis 37.3 auf einer geeignet gewählten (diagonalen) Linie vorgegeben, während die Position der Reflektoren 38.1 bis 38.6 von Transponder zu Transponder variiert entsprechend dem jeweils zu implementierenden Code. Bei Codierung durch Positionieren der Transducer 37.1 bis 37.3 sind umgekehrt die Positionen der Reflektoren 38.1 bis 38.6 fest vorgegeben, während die Position der Transducer 37.1 bis 37.3 von Transponder zu Transponder entsprechend dem zu verwirklichenden Code ändert. Die Reflektoren 38.1, 38.3 und 38.5 einerseits, sowie 38.2, 38.4 und 38.6 andererseits können dann z. B. auf einer gemeinsamen, zum entsprechenden nächsten Rand des SAW-Chips 21 parallelen Linie angeordnet sein.

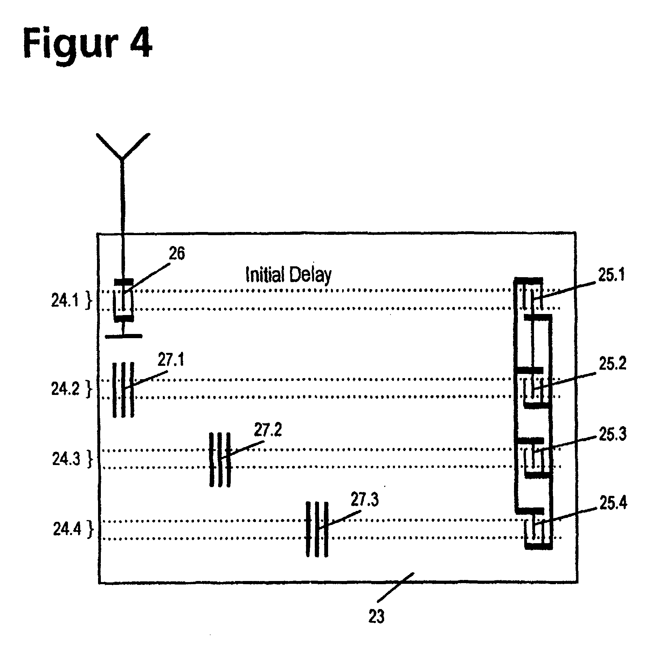

Bei fest vorgegebener Apertur eines akustischen Kanals nimmt die Dämpfung der Oberflächenwellen mit der Distanz zu. Um nun die Dämpfung in längeren Kanälen zu reduzieren, kann die Apertur vergrössert werden. Es ist deshalb von Vorteil, wenn längere Codierkanäle eine grössere Apertur als kürzere haben. Da der akustische Kanal 22.4, der als Signalstrecke dient, wie bereits erwähnt meist die grösste Länge haben wird, ist seine Apertur mit Vorteil grösser als diejenige der Codierkanäle. Die erfindungsgemässe Abspaltung der gemeinsamen Signalverzögerung (in einem eigenständigen akustischen Kanal) erlaubt daher auch eine Optimierung der Verhältnisse der Aperturen der verschiedenen Codierkanäle. Dies ist besonders einfach zu realisieren bei der nachfolgend beschriebenen Ausführungsform gemäss Fig. 4 (d. h. Codierkanal = akustischer Kanal). Optimierung der Signaldämpfung und Minimierung der Chipfläche können infolgedessen bei der Erfindung Hand in Hand gehen.

In der Ausführungsform gemäss Fig. 4 sind wiederum auf einem einzigen SAW-Chip 23 ein eigenständiger akustischer Kanal 24.1 für die gemeinsame Anfangsverzögerung $T_0$ und drei akustische Kanäle 24.2 bis 24.4 für die Signalcodierung vorgesehen. Von der Antenne wird das elektrische Signal über eine erste Transducerelektrode 26 am einen Ende des Kanals 24.1 eingespeist. Am gegenüberliegenden Ende des Kanals 24.1 greift eine Transducerelektrode 25.1 die Oberflächenwellen ab und überträgt ein entsprechendes elektrisches Signal an die parallelgeschalteten Transducerelektroden 25.2 bis 25.4 in den Kanälen 24.2 bis 24.4. Die Transducerelektroden 25.1 bis 25.4 sind dabei an einer Seite des SAW-Chips 23 in einer Linie angeordnet. Die zur Codierung erforderlichen Reflektoren 27.1 bis 27.3 sind in den Kanälen 24.2 bis 24.4 in codespezifischen Positionen angebracht (codespezifisch heisst z. B., dass die Reflektoren 27.1 bis 27.3 in unterschiedlichen Transpondern des Systems unterschiedliche Positionen haben).

Der Vorteil der geometrischen Anordnung gemäss Fig. 4 besteht darin, dass die elektrischen Verbindungsleitungen zwischen den Transducerelektroden 25.1 bis 25.4 relativ kurz sind und daher Widerstandsverluste minimiert werden können. Auch haben die einseitig abstrahlenden Transducerelektroden 25.2 bis 25.4 kleinere Verluste als die zweiseitig abstrahlenden gemäss Fig. 3. Allerdings hat die Ausführungsform gemäss Fig. 4 nur halb soviele Codierkanäle wie diejenige gemäss Fig. 3. Entsprechend ist die Zahl der zur Verfügung stehenden Codes geringer.

Wenn die Verluste in den elektrischen Verbindungen zwischen den Transducerelektroden 25.1 bis 25.4 minimiert werden sollen, dann kann es von Vorteil sein, den als laufzeiterhöhende Signalstrecke dienenden akustischen Kanal in der Mitte (statt am Rand wie in Fig. 4) zu plazieren. Die in Fig. 4 gezeigten Verbindungsleitungen (busbars) sollen einen kleinen Widerstand im Sinne des folgenden Kriteriums aufweisen:

$$2\pi f * R * C \ll 1$$

R bezeichnet den parasitären Leitungswiderstand, C die gesamte statische Kapazität der IDT-Elektrodenstruktur (IDT = interdigital transducer) und f die Arbeitsfrequenz (z. B. f = 2.45 GHz).

Bei der erfindungsgmässen Auslagerung einer gemeinsamen Verzögerungsstrecke können die störenden internen Reflexionen durch die nachfolgend beschriebenen Massnahmen (insbesondere 90°-Reflektoren und RMSC-Strukturen) gegenüber den Antwortsignalkomponenten stark (z. B. mehr als -20 dB) reduziert werden.

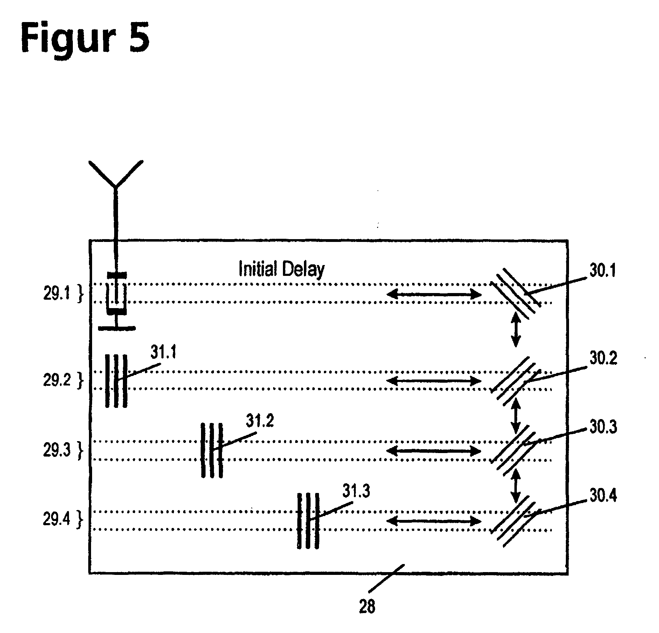

Fig. 5 zeigt eine Variante zu Fig. 4, bei welcher die Kopplung zwischen den akustischen Kanälen 29.1 bis 29.4 des SAW-Chips 28 nicht mit Hilfe von Transducerelektroden, sondern mit entsprechend angeordneten 90°-Reflektoren 30.1 bis 30.4 erfolgt. Der in der Darstellung gemäss Fig. 5 zuoberst angeordnete Kanal 29.1 verfügt über einen 90°-Reflektor 30.1, welcher die Oberflächenwellen aus dem Kanal im 90°-Winkel hinausreflektiert (in der Darstellung gemäss Fig. 5 nach "unten"). Die 90°-Reflektoren 30.2 bis 30.4 sind so auf den 90°-Reflektor 30.1 ausgerichtet, dass ein Teil der im 90°-Winkel ausgekoppelten Oberflächenwelle in den jeweiligen Kanal 29.2 bis 24.4 eingekoppelt wird. Dort läuft sie zu den Reflektoren 31.1, 31.2, 31.3 (180°-Reflektoren), wird reflektiert und über die 90°-Reflektoren wieder zurück in den Kanal 29.1 gelenkt.

Der Winkel zwischen den schräg verlaufenden Fingerelektroden der 90°-Reflektoren und der kristallografischen x-Koordinate ist nahe bei 45° und hängt von der Anisotropie des benutzten Substrats ab. (Für die - in anderem Zusammenhang an sich bekannte - Bemessung solcher 90°-Reflektoren wird auf das Buch "Surface-wave devices for signal processing", D. Morgan, Elsevier, 1985, verwiesen.)

Eine Variante könnte auch darin bestehen, dass nur der 90°-Reflektor 30.1 vorhanden ist und dass die Codierkanäle direkt in Richtung der um 90° umgelenkten Oberflächenwelle liegen. D. h. die Reflektoren 31.1 bis 31.3 werden in einem einzigen Kanal (senkrecht zum Kanal 29.1) und ausgerichtet auf den 90°-Reflektor 30.1 angeordnet. Denkbar wäre auch, dass im Kanal 29.1 mehrere 90°-Reflektoren vorgesehen sind (z. B. für jeden Codierkanal einer), wobei die akustischen Kanäle für die Codierung parallel zueinander aber senkrecht zum laufzeiterhöhenden Kanal 29.1 stehen würden.

Die Ausführungsform gemäss Fig. 5 hat folgende Vorteile:

1. Da die Periodizität der Elektroden für die schrägen Reflektoren in x-Richtung gleich der Wellenlänge (Lambda) sein muss, beträgt die Breite der Elektrodenfinger etwa Lambda/$2\sqrt{2}$. D. h. sie ist um den Faktor $\sqrt{2}$ grösser als die entsprechende Breite von Lambda/4 für die mit senkrecht einfallenden Wellen arbeitenden Reflektoren. Das ist ein wichtiger Vorteil für den 2.45 GHz-Frequenzbereich.

2. Die Widerstandsverluste in den Elektroden sind kleiner, da kein elektrischer Stromfluss von einer Elektrode zur anderen existiert (alle Ströme sind lokal).

3. Der 90°-Reflektor ist nicht empfindlich auf (herstellungsbedingte) Kurzschlüsse zwischen den Fingern oder Unterbrüche in den Fingern.

4. Es gibt nahezu keine störenden internen Reflexionen, wodurch insbesondere auch parasitäre Dreifachreflexionen (zwischen den Reflektoren) wegfallen.

5. Die Wellenausbreitung quer zur x-Koordinate des Kristalls führt zusätzliche und im Rahmen der Erfindung bevorzugte Signalverzögerungen ein. Entsprechend kann die Chipfläche optimiert bzw. minimiert werden.

6. Die Dämpfungsverluste (attenuation loss) können kompensiert werden sowohl durch Verändern der Anzahl Finger in den 90°- bzw. 180°-Reflektoren als auch durch Aendern der Apertur der Kanäle.

Insgesamt zeichnet sich diese Ausführungsform somit durch eine grosse Flexibilität bei der Dimensionierung, eine heute erleichterte Herstellbarkeit (höhere Ausbeute) und durch erheblich reduzierte interne Störreflexe aus.

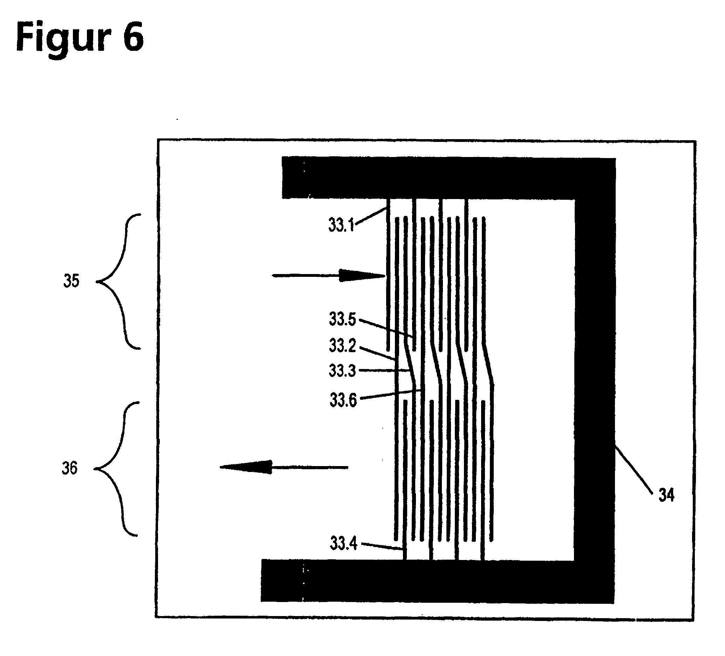

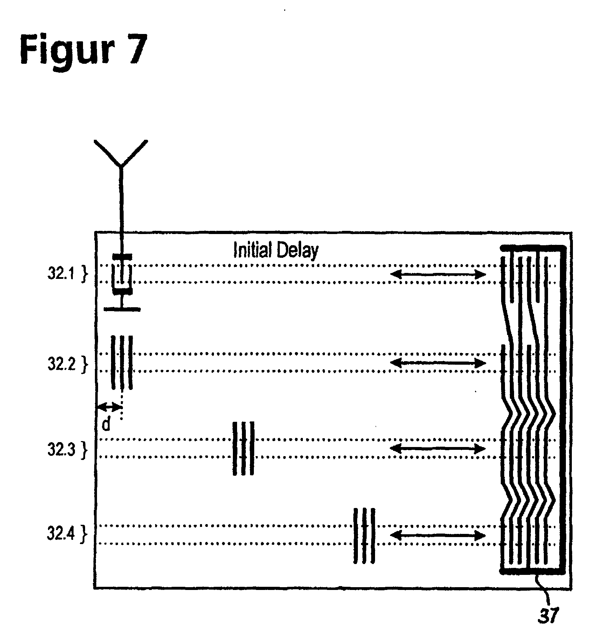

Fig. 7 zeigt eine weitere Möglichkeit, einen laufzeitverzögernden Kanal 32.1 mit codierenden Kanälen 32.2 bis 32.4 zu koppeln. Die Kopplung erfolgt mit einer RMSC-Struktur (Reversing multistrip coupler), wie sie beispielhaft in Fig. 6 dargestellt ist.

Es handelt sich dabei um eine Elektrodenstruktur auf einem piezoelektrischen Substrat mit drei Elektrodenfingern 33.1, 33.2, 33.3 pro Periode (Wellenlänge) im Kanal 35 resp. 33.4, 33.3, 33.6. Sie erstreckt sich über zwei oder mehrere akustische Kanäle. Jeweils zwei Elektrodenfinger in jeder Gruppe (Periode) sind in der relativen Reihenfolge vertauscht. Um technologisch aufwendige und damit teure Elektrodenüberkreuzungen vermeiden zu können, ist die Struktur der Elektrodenfinger 33.1, 33.2 etc. von einer ring- (bzw. C-)förmigen Elektrode 34 umgeben (ring ground electrode).

Aus Fig. 6 ist folgendes zu erkennen: Der erste Elektrodenfinger 33.1 ist am oberen Seitenarm der Elektrode 34 angeschlossen und erstreckt sich nur über den ersten Kanal 35. In einem kleinen (durch die Wellenlänge vorgegebenen) Abstand befindet sich parallel der nächste Elektrodenfinger 33.2. Er erstreckt sich über beide Kanäle 35 und 36, ist aber an keinem der beiden Arme der Elektrode 34 angeschlossen. Der Elektrodenfinger 33.3 ist ebenfalls nicht an der Elektrode 34 angeschlossen. Er erstreckt sich über beide Kanäle 35, 36. Der nächste Elektrodenfinger 33.5 wiederum ist wie der erste Elektrodenfinger 33.1 nur am oberen Arm der Elektrode 34 angeschlossen und erstreckt sich nur über den oberen Kanal 35. Im unteren Kanal 36 kommt der Elektrodenfinger 33.4 als erster in der Periode. (Er erstreckt sich nur über den unteren Kanal 36 und ist auch nur am unteren Arm der Elektrode 34 angeschlossen.) Als nächstes folgt der Elektrodenfinger 33.3 und als drittes der Elektrodenfinger 33.6. Die Struktur der Elektrodenfinger 33.1, 33.2, 33.3 setzt sich im oberen Kanal 35 periodisch fort. Dasselbe gilt für die Elektrodenfinger 33.4, 33.3, 33.6. Vertauscht sind also die relativen Positionen des zweiten und dritten Elektrodenfingers in jeder Periode. Die Elektrodenfinger 33.1 und 33.4 können statt über die Elektrode 34 auch direkt (d. h. durch Ueberkreuzen des Elektrodenfingers 33.2) verbunden werden. Allerdings ist diese Variante herstellungstechnisch aufwendiger und daher weniger bevorzugt. Weitere Erläuterungen der als solche bekannten RMSC-Struktur erübrigen sich (vgl. z. B. E. Danicki, "A SAW resonator filter exploiting RMSCs", 1994, Frequency Control Symp. Proc.).

Die vertauschten Elektrodenfinger führen dazu, dass die durch die einfallende akustische Oberflächenwelle im Kanal 35 erzeugte Potentialwelle im Kanal 36 zu einer entgegengesetzt laufenden Potential- bzw. Oberflächenwelle führt (sofern die Periode der Elektrodenstruktur der Wellenlänge angepasst ist d. h. ungefähr gleich gross ist).

Die RMSC-Struktur kann auf der Grundfrequenz und der zweiten Harmonischen arbeiten. Die Breite der Elektroden bei Betrieb in der Grundfrequenz ergibt sich zu Lambda/6 (z. B. Lambda/6 = 0,26 μm bei Grundfrequenz 2.45 GHz).

Bei Betrieb in der zweiten Harmonischen ergibt sich eine vorteilhafte Verdoppelung der Elektrodenbreite (z. B. 0,52 μm ).

RMSC-Strukturen haben diverse Vorteile. Sie arbeiten auf der Basis einer elektromechanischen Kopplung der Oberflächenwellen und der elektrischen Felder. Ein besonders wichtiger Vorteil ist dabei, dass die störende Rückwärtsreflexion in denselben Kanal sehr schwach ist. Insbesondere können die störenden Reflexionen am Transducer 18.2 (Fig. 1) und Mehrfachrefiexionen in den Codierkanälen 32.2, ..., 32.4 sehr stark reduziert werden. Weiter ist die Wellenübertragung und Reflexion vom einen Kanal in den anderen fast vollständig, wenn die Zahl der Elektrodenfinger hinreichend gross ist, d. h. von der Grössenordnung 3 * (DeltaV/V)$^{-1}$, wobei DeltaV/V der an sich bekannte Kopplungsfaktor zur Beschreibung der Stärke des Piezoeffektes bei akustischen Oberflächenwellen ist.

Die Ausführungsform gemäss Fig. 7 verwendet also eine RMSC-Struktur wie sie anhand der Fig. 6 näher erläutert worden ist. Die C-förmige Elektrode 37 umgreift alle vier akustischen Kanäle 32.1 bis 32.4. Der Kanal 35 in Fig. 6 entspricht in Fig. 7 dem Kanal 32.1 für die Laufzeitverzögerung. Der Kanal 36 gemäss Fig. 6 ist in der Ausführungsform gemäss Fig. 7 auf drei getrennte akustische Kanäle 32.2 bis 32.4 zur Codierung aufgeteilt. Die im obersten Kanal 32.1 auf die RMSC-Struktur fallende Welle wird also in die drei Kanäle 32.2 bis 32.4 gekoppelt und mit umgekehrter Ausbreitungsrichtung ausgestrahlt. Sinngemäss werden die codespezifischen Reflexionen aus den Kanälen 32.2 bis 32.4 in den Kanal 32.1 zurückgeführt und dort in entgegengesetzter Richtung ausgestrahlt. Gemäss einer besonders bevorzugten Ausführungsform sind die Elektrodenfinger zwischen den codierenden akustischen Kanälen 32.2 und 32.3 resp. 32.3 und 32.4 V-förmig deformiert. Dadurch wird verhindert, dass Oberflächenwellen zwischen den akustischen Kanälen 32.2 bis 32.4 ausgestrahlt werden. Selbstverständlich können anstelle der V-förmigen auch andere Deformationen vorgesehen sein (zur Verhinderung unerwünschter SAW-Abstrahlung).

Es ist zwar möglich, dass Reflexionen aus einem codierenden Kanal (z. B. 32.4) in einen anderen (z. B. 32.3) gekoppelt werden. Da die Elektrodenfinger in allen codierenden Kanälen die gleiche Reihenfolge haben, gibt es jedoch keine Richtungsumkehr, so dass die erwähnte Einkopplung in die falsche Richtung (d. h. nicht gegen die Reflektoren) erfolgt und infolgedessen ausser Betracht fällt.

Als Substrat für das SAW-Element wird vorzugsweise 128-LiNbO3 verwendet. Dieses Material zeichnet sich durch starke piezoelektrische Kopplung aus, was wichtig zur Verminderung der Verluste von verhältnismässig breitbandigen Transducern ist. Weiter hat dieses Material eine hohe Oberflächenwellen-Geschwindigkeit und ein niedriges Niveau parasitärer Bulk-Wellen. Andere Substrate sind jedoch ebenfalls möglich. Für die Ausführungsform mit den 90°-Reflektoren beispielsweise ist YZ-LiNbO$_3$ von Vorteil wegen den geringen Streuverlusten (diffraction losses).

Die Transducer können als sog. "split electrode transducers" ausgebildet sein, welche auf der dritten Harmonischen arbeiten. In diesem Fall ist die Breite der Elektrode für 128-LiNbO$_3$ etwa 0,6 μm (so auch die Abstände zwischen den Elektrodenfingern). Für sog. "self-matched" Transducer (d. h. Transducer, bei welchen der imaginäre Teil der Admittanz nahe bei Null ist), benötigt man eine Struktur mit etwa 25 gespaltenen Elektroden (50 Elektrodenfinger). Der Realteil der Admittanz ist nahe bei 50 Ohm, wenn die Apertur nahe bei 100 Lambda (Lambda = Wellenlänge der Oberflächenwelle, z. B. 1,6 μm bei 2.45 GHz) ist. Die Dauer der Stossantwort eines solchen Transducers ist etwa 15 ns.

Die Reflektoren können entweder bei der Grundfrequenz oder bei der dritten Harmonischen arbeiten. Im erstgenannten Fall können einzelne kurzgeschlossene Elektroden (single short circuited electrodes) mit einer geometrischen Periode (pitch) p = Lambda/2 (p = 0,8 μm für 128-LiNbO$_3$ bei 2.45 GHz) und mit einer entsprechenden Breite der Elektrodenfinger von Lambda/4 (= 0,4 μm für LiNbO$_3$ bei 2.45 GHz) eingesetzt werden. Für eine starke Totalreflexion werden 40 bis 50 Elektrodenfinger gebraucht. Dies bedeutet eine Zeitverzögerung innerhalb der Reflektoren von etwa 16 ns. Da die herstellungstechnischen Anforderungen an Elektroden mit einer Breite von 0,4 μm hoch sind, werden oft gespaltene Elektrodenfinger (split electrodes) verwendet, welche bei der dritten Harmonischen arbeiten und deren Breite beträgt ca. 0,6 μm für LiNbO$_3$ bei 2.45 GHz. Die Zahl der gespaltenen Elektroden liegt im Bereich von typischerweise 15 bis 25.

Die Zahl der akustischen Kanäle wird einerseits durch die gewünschte Zahl möglicher Codierungen und andererseits durch die Grösse des SAW-Elements (Chipgrösse) bestimmt. Für die folgenden Ueberlegungen wird angenommen, dass alle akustischen Kanäle dieselbe Breite und einen konstanten gegenseitigen Abstand haben. Ebenso wird angenommen, dass der Abstand zum Rand des SAW-Chips von etwa gleicher Grösse ist. Ein zusätzlicher Kanal wird für die erfindungsgemässe laufzeiterhöhende Signalstrecke 12 verwendet (initial delay channel).

Wenn $W_{CH}$ die Breite eines einzelnen Kanals (Apertur) und $N_{CH}$ die Zahl der Kanäle ist, dann gilt:

$$\text{I} \qquad \text{Chipbreite} \approx W_{CH} * (2 * N_{CH} + 3)$$

$$\text{II} \qquad \text{Chiplänge} \approx 2 * d + (M+1) * N_{CH} * V/B$$

d = 50-100 μm ist der Abstand linksseitig zwischen den Reflektoren und dem Rand des SAW-Chips (vgl. z. B. Fig. 7). B ist die Frequenzbandbreite des Abfragesignals (z. B. B = 40 MHz). 1/B ist die kleinste detektierbare Zeitverzögerungsänderung in der Codierung (z. B. 1/B = 25 ns). Im vorliegenden Beispiel wird die Breite eines Zeitschlitzes gerade zu 1/B gewählt. M ist die Zahl der vorgesehenen Codierpositionen (Zeitschlitze) für jeden Reflektor in einem Codierkanai. Der Codierbereich eines Reflektors hat eine Länge von (M+1) * V/2B, wobei beispielsgemäss die Zahl der Positionen M um 1 erhöht ist (dies entspricht der Situation dS = $s_{11}$ = $s_{12}$ = ... = s = 1/B = 25 ns), um zu erreichen, dass der geringstmögliche Zeitabstand zwischen zwei aufeinanderfolgenden Signalkomponenten nicht kleiner als dS + s beträgt. Der geringste Abstand zwischen den Pulsen ist also z. B. 50 ns.

Einer gemeinsamen Signalverzögerung von $t_{init}$ = 0,7 μs entspricht eine theoretische Minimallänge des SAW-Chips von ca. 1,4 mm.

Für ein kleines 5 * 5 mm² Gehäuse mit einer erlaubten Chipgrösse von 3,6 * 1,7 mm² ergibt sich aus dem Gleichungen I und II:

$$N_{CH} \leq 6 \qquad (\text{bei } w_{CH} = 112 \ \mu m)$$

$$(M+1) * N_{CH} \leq 35 \ (\text{bei } d = 50 \ \mu m, \ v/B = 1/10 \ mm)$$

Die Länge von 3,5 mm entspricht etwas weniger als 2200 Lambda (bei 2.45 GHz). Die Apertur eines Kanals kann daher weniger als 50 Lambda sein, ohne dass Streuprobleme auftauchen. Mit einer gewissen Reserve kann $W_{CH}$ = 70 Lambda gesetzt werden. Bei der Wahl $N_{CH}$ = 6 und M = 5 ergeben sich $5^{12}$ Codemöglichkeiten. Es ist offensichtlich, dass diese Anzahl Bits nahezu verdoppelt werden kann, wenn kleinere Aperturen für kürzere Kanäle verwendet werden.

Bereits ohne weitere Optimierung ergibt sich mit der Erfindung und der obigen Wahl der Parameter die Möglichkeit von mehr als 1000 Chips pro 4 Zoll Wafer.

Die verschiedenen Ausführungsformen können untereinander kombiniert bzw. abgewandelt werden. Die verschiedenen Arten, die akustischen Kanäle zu koppeln, können im Prinzip kombiniert werden. Akustische Kanäle können parallel und seriell geschaltet sein. Die Anordnung der verschiedenen Kanäle ist vorzugsweise im Sinn minimaler Verluste, eines minimalen Flächenbedarfs und minimaler interner Störreflexe gewählt. Beim Stand der Technik gemäss US-4,737,790 sind die SAW-Elemente zwar relativ schmal, dafür sehr lang. Bei der Erfindung kann die Länge ohne weiteres auf einen Drittel reduziert werden.

Die Erfindung beschränkt sich im Prinzip nicht auf die Anwendung bei SAW-Elementen. Vielmehr kann sie überall dort von Nutzen sein, wo mehrere signalcodierende bzw. -verarbeitende Kanäle parallel betrieben werden und laufzeiterhöhende Signalstrecken vorhanden sind, die für alle Kanäle gemeinsam in einem vorgeschalteten bzw. nachgeschalteten Element untergebracht sein können.

**Patentansprüche**

**1.** Verfahren zum Durchführen einer berührungslosen Fernabfrage, wobei

a) eine Abfragestation (1) ein Abfragesignal (Q) an einen mobilen Transponder (2) aussendet und

b) dieses Abfragesignal (Q) im Transponder (2) mit einer Antenne (10) empfangen, durch Einkoppeln in mehrere parallele Codierkanäle (14.1 bis 14.6) in ein codiertes Antwortsignal umgewandelt und dann an die Abfragestation zurückgesendet wird,
**dadurch gekennzeichnet, dass**

c) Abfrage- und Antwortsignal im Transponder (2) durch eine zwischen den genannten Codierkanälen (14.1 bis 14.6) und der Antenne (10) geschaltete, gemeinsame laufzeiterhöhende Signalstrecke (12) geführt werden, um das Antwortsignal von störenden Umgebungsreflexionen des Abfragesignals (Q) zu trennen.

**2.** Verfahren nach Anspruch 1, **dadurch gekennzeichnet, dass** das Abfragesignal (Q) bei der Umwandlung in ein Antwortsignal laufzeitcodiert wird.

**3.** Verfahren nach Anspruch 1 oder 2, **dadurch gekennzeichnet, dass** mindestens ein Codierkanal (14.1 bis 14.6) eine Referenzsignalkomponente erzeugt, so dass das Antwortsignal sowohl identifizierende als auch zu Kalibrier- und/oder Messzwecken dienende Signalkomponenten enthält.

4. Verfahren nach einem der Ansprüche 1 bis 3, **dadurch gekennzeichnet, dass** in mindestens einem Codierkanal eine nicht der Identifikation dienende Signalkomponente zur Temperaturmessung am Ort des Transponders (2) erzeugt und in der Abfragestation (1) ausgewertet wird.

5. Anordnung zur Durchführung des Verfahrens nach einem der Ansprüche 1 bis 4, mit

   a) einer Abfragestation (1) zum Aussenden eines Abfragesignals (Q) und Auswerten eines Antwortsignals,

   b) mindestens einem mobilen Transponder (2) mit einer Antenne (10) zum Empfangen des Abfragesignals (Q) und/oder Abstrahlen des Antwortsignals und

   c) mindestens einer Codiereinheit (13.1) mit mehreren parallelen Codierkanälen (14.1 bis 14.6) zum Umwandeln des Abfragesignals (Q) in ein Antwortsignal durch Codierung, **dadurch gekennzeichnet, dass**

   d) vor bzw. nach der mindestens einen Codiereinheit (13.1) eine für die genannten Codierkanäle (14.1 bis 14.6) gemeinsame laufzeiterhöhende Signalstrecke (12) angeordnet ist.

6. Transponder geeignet für eine Anordnung nach Anspruch 5 mit einer Codiereinheit (13.1) mit mehreren Codierkanälen (14.1 bis 14.6), **gekennzeichnet durch** eine der Codiereinheit (13.1) vor- bzw. nachgeschaltete laufzeiterhöhende Signalstrecke (12) auf einem SAW-Element.

7. SAW-Element geeignet für einen Transponder nach Anspruch 6, **dadurch gekennzeichnet, dass** es über mehrere parallele Codierkanäle (14.1 bis . 14.6) und über eine separate Signalstrecke (12) verfügt und dass die Signalstrecke ein akustischer Kanal (24.1; 29.1; 32.1) ist, der mit einer Mehrzahl parallel geschalteter akustischer Kanäle (24.2 bis 24.4; 29.2 bis 29.4; 32.2 bis 32.4), welche die Codierkanäle (14.1 bis 14.6) enthalten, gekoppelt ist.

8. SAW-Element nach Anspruch 7, **dadurch gekennzeichnet, dass** die akustischen Kanäle (15.1, 15.2, 15.3; 24.1 bis 24.4) durch Transducerelektroden (16.1, 16.2, 16.3; 25.1 bis 25.4) gekoppelt sind.

9. SAW-Element nach Anspruch 7, **dadurch gekennzeichnet, dass** die akustischen Kanäle (29.1 bis 29.4) durch 90°-Reflektoren (30.1 bis 30.4) gekoppelt sind.

10. SAW-Element nach Anspruch 7, **dadurch gekennzeichnet, dass** die akustischen Kanäle (32.1 bis 32.4) durch eine RMSC-Struktur (34) gekoppelt sind.

11. SAW-Element nach einem der Ansprüche 7 bis 10, **dadurch gekennzeichnet, dass** die Codierkanäle (14.1 bis 14.6) zur Erzeugung von Laufzeitcodierungen ausgebildet sind.

12. SAW-Element nach einem der Ansprüche 7 bis 11, **dadurch gekennzeichnet, dass** die akustischen Kanäle (15.1 bis 15.3) mit beidseitig abstrahlenden Transducern (16.1 bis 16.3) ausgestattet sind und dass beidseits der Transducer (16.1 bis 16.3) Reflektoren (17.1 bis 17.6) in codespezifischen Abständen angeordnet sind.

13. SAW-Element nach einem der Ansprüche 7 bis 11, **dadurch gekennzeichnet, dass** die akustischen Kanäle (24.2 bis 24.4) mit einseitig abstrahlenden Transducern (25.2 bis 25.4) ausgestattet sind und dass auf der abstrahlenden Seite Reflektoren (27.1 bis 27.3) in codespezifischen Abständen angeordnet sind.

14. SAW-Element nach einem der Ansprüche 12 oder 13, **dadurch gekennzeichnet, dass** die Transducer (25.2 bis 25.4) in akustischen Kanälen (24.2) mit grösserer Laufzeit mehr Elektrodenfinger haben als in Kanälen (24.3, 24.4) mit kleinerer Laufzeit und/oder die Kanäle eine Apertur haben, die ihrer Signallaufzeit angepasst ist.

15. SAW-Element nach einem der Ansprüche 7 bis 14, **dadurch gekennzeichnet, dass** die Codierkanäle so ausgebildet sind, dass eine Laufzeit-, Phasen-, Amplituden- oder Pulsformcodierung erfolgt.

**Claims**

1. Method of performing a contact-free remote inquiry, wherein

   a) an inquiry station (1) transmits an inquiry signal (Q) to a mobile transponder (2) and

   b) said inquiry signal (Q) is received in said transponder (2) with an antenna (10), converted into an encoded response signal by coupling into several parallel encoding channels (14.1 to 14.6) and then sent back to said inquiry station, **characterized in that**

c) said inquiry and response signals are guided in said transponder (2) through a common propagation-time-increasing signal path (12) connected between said encoding channels (14.1 to 14.6) and said antenna (10)

in order to separate said response signal from interfering ambient reflections of the response signal (Q).

2. Method according to claim 1, **characterized in that** said response signal (Q) is propagation-time encoded during its conversion into a response signal.

3. Method according to claims 1 or 2, **characterized in that** at least one encoding channel (14.1 to 14.6) generates a reference signal component so that said response signal contains identifying signal components as well as signal components serving for calibrating and/or measuring purposes.

4. Method according to any one of claims 1 to 3, **characterized in that** a signal component not serving for identification purposes, which is used for temperature measurements, is generated at the location of said transponder (2) in at least one encoding channel and is evaluated in said inquiry station (1).

5. Arrangement for performing the method according to any one of claims 1 to 4, comprising

a) an inquiry station (1) for transmitting an inquiry signal (Q) and evaluating a response signal,

b) at least one mobile transponder (2) with an antenna (10) for receiving said inquiry signal (Q) and/or for transmitting said response signal and

c) at least one encoding unit (13.1) with several parallel encoding channels (14.1 to 14.6) for converting said inquiry signal (Q) into a response signal by encoding,
**characterized in that**

d) a propagation-time-increasing signal path (12) common to said encoding channels (14.1 to 14.6) is arranged upstream or downstream of said at least one encoding unit (13.1).

6. Transponder suitable for an arrangement according to claim 5 with an encoding unit (13.1) with several encoding channels (14.1 to 14.6), **characterized by** a propagation-time-increasing signal path (12) on an SAW-device upstream or downstream connected to said encoding unit (13.1).

7. SAW-device suitable for a transponder according to claim 6, **characterized in that** it comprises several parallel encoding channels (14.1 to 14.6) and a separate signal path (12) and that said signal path is an acoustic channel (24.1; 29.1; 32.1) which is coupled to a plurality of acoustic channels (24.2 to 24.4; 29.2 to 29.4; 32.2 to 32.4) connected in parallel, which contain the encoding channels (14.1 to 14.6).

8. SAW-device according to claim 7, **characterized in that**. the acoustic channels (15.1, 15.2, 15.3; 24.1 to 24.4) are coupled via transducer electrodes (16.1, 16.2, 16.3; 25.1 to 25.4).

9. SAW-device according to claim 7, **characterized in that** the acoustic channels (29.1 to 29.4) are coupled by 90°-reflectors (30.1 to 30.4).

10. SAW-device according to claim 7, **characterized in that** the acoustic channels (32.1 to 32.4) are coupled via an RMSC-structure (34).

11. SAW-device according to any one of claims 7 to 10, **characterized in that** the encoding channels (14.1 to 14.6) are configured for generating propagation time encodings.

12. SAW-device according to any one of claims 7 to 11, **characterized in that** the acoustic channels (15.1 to 15.3) are provided with two-side radiating transducers (16.1 to 16.3) and that on both sides of the transducers (16.1 to 16.3) reflectors (17.1 to 17.6) are disposed at code-specific distances.

13. SAW-device according to any one of claims 7 to 11, **characterized in that** the acoustic channels (24.2 to 24.4) are provided with one-side radiating transducers (25.2 to 25.4) and that reflectors (27.1 to 27.3) are disposed at code-specific distances on the radiating side.

14. SAW-device according to any one of claims 12 or 13, **characterized in that** said transducers (25.2 to 25.4) in acoustic channels (24.2) with a longer propagation time comprise more electrode fingers than in channels (24.3, 24.4) with a shorter propagation time and/or said channels have an aperture which is adapted to their signal propagation time.

15. SAW-device according to any one of claims 7 to 14, **characterized in that** the encoding channels are configured so that a propagation time, phase, amplitude, or pulse-shape encoding takes place.

**Revendications**

1. Procédé pour effectuer une interrogation à distance sans contact, où

a) un poste d'interrogation (1) envoie un signal d'interrogation (Q) à un transpondeur mobile (2) et

b) ce signal d'interrogation (Q) est reçu dans le transpondeur (2) par une antenne (10), transformé en un signal de réponse codé par injection dans plusieurs canaux de codage parallèles (14.1 à 14.6), puis renvoyé au poste d'interrogation,

**caractérisé en ce que**

c) le signal d'interrogation et le signal de réponse sont conduits dans le transpondeur (2) sur un parcours de signal commun (12) augmentant la durée de propagation, couplé entre les canaux de codage (14.1 à 14.6) et l'antenne (10), afin de séparer le signal de réponse de réflexions ambiantes perturbatrices du signal d'interrogation (Q).

2. Procédé selon la revendication 1, **caractérisé en ce que** le signal d'interrogation (Q) est codé en temps de propagation lors de sa transformation en un signal de réponse.

3. Procédé selon la revendication 1 ou 2, **caractérisé en ce qu'**au moins un canal de codage (14.1 à 14.6) produit une composante du signal de référence de telle sorte que le signal de réponse contient des composantes de signal servant aussi bien à des fins d'identification que de calibrage et/ou de mesure.

4. Procédé selon l'une des revendications 1 à 3, **caractérisé en ce que** dans au moins un canal de codage une composante de signal ne servant pas à l'identification est produite pour la mesure de la température à l'endroit du transpondeur (2) et est évaluée dans le poste d'interrogation (1).

5. Disposition pour l'exécution du procédé selon l'une des revendications 1 à 4, avec

a) un poste d'interrogation (1) pour l'envoi d'un signal d'interrogation (Q) et l'évaluation d'un signal de réponse,

b) au moins un transpondeur mobile (2) avec une antenne (10) pour la réception du signal d'interrogation (Q) et/ou l'émission du signal de réponse et

c) au moins une unité de codage (13.1) avec plusieurs canaux de codage parallèles (14.1 à 14.6) pour la transformation par codage du signal d'interrogation (Q) en un signal de réponse,

**caractérisée en ce que**

d) avant ou après la au moins une unité de codage (13.1) est disposé pour lesdits canaux de codage (14.1 à 14.6) un parcours de signal (12) commun augmentant le temps de propagation.

6. Transpondeur propre à une disposition selon la revendication 5 avec une unité de codage (13.1) comportant plusieurs canaux de codage (14.1 à 14.6), **caractérisé par** un parcours de signal (12) augmentant le temps de propagation, placé avant ou après l'unité de codage (13.1) sur un élément à ondes acoustiques de surface.

7. Élément à ondes acoustiques de surface propre à un transpondeur selon la revendication 6, **caractérisé en ce qu'**il dispose de plusieurs canaux de codage parallèles (14.1 à 14.6) et d'un parcours de signal (12) séparé et **en ce que** le parcours de signal est un canal acoustique (24.1 ; 29.1 ; 32.1), qui est couplé avec une pluralité de canaux acoustiques branchés en parallèle (24.2 à 24.4 ; 29.2 à 29.4 ; 32.2 à 32.4), lesquels contiennent les canaux de codage (14.1 à 14.6).

8. Élément à ondes acoustiques de surface selon la revendication 7, **caractérisé en ce que** les canaux acoustiques (15.1, 15.2, 15.3 ; 24.1 à 24.4) sont couplés par des électrodes de transducteur (16.1, 16.2, 16.3 ; 25.1 à 25.4).

9. Élément à ondes acoustiques de surface selon la revendication 7, **caractérisé en ce que** les canaux acoustiques (29.1 à 29.4) sont couplés par des réflecteurs à 90° (30.1 à 30.4).

10. Élément à ondes acoustiques de surface selon la revendication 7, **caractérisé en ce que** les canaux acoustiques (32.1 à 32.4) sont couplés par une structure RMSC (34).

11. Élément à ondes acoustiques de surface selon l'une des revendications 7 à 10, **caractérisé en ce que** les canaux de codage (14.1 à 14.6) sont conçus pour produire les codages de temps de propagation.

12. Élément à ondes acoustiques de surface selon l'une des revendications 7 à 11, **caractérisé en ce que** les canaux acoustiques (15.1 à 15.3) sont équipés de transducteurs (16.1 à 16.3) émettant des deux côtés et **en ce que** des deux côtés des transducteurs (16.1 à 16.3) sont disposés des réflecteurs (17.1 à 17.6) par intervalles spécifiques au codage.

13. Élément à ondes acoustiques de surface selon l'une des revendications 7 à 11, **caractérisé en ce que** les canaux acoustiques (24.2 à 24.4) sont équipés de transducteurs émettant sur un côté (25.2 à 25.4) et **en ce que** sur le côté émetteur sont disposés des réflecteurs (27.1 à 27.3) par intervalles spécifiques au codage.

14. Élément à ondes acoustiques de surface selon l'une des revendications 12 ou 13, **caractérisé en ce que** les transducteurs (25.2 à 25.4) ont plus de doigts d'électrodes dans les canaux acoustiques (24.2) à temps de propagation plus long que dans les canaux (24.3, 24.4) avec temps de propagation plus court et/ou les canaux ont une ouverture adaptée à leur temps de propagation de signal.

15. Élément à ondes acoustiques de surface selon l'une des revendications 7 à 14, **caractérisé en ce que** les canaux de codage sont conçus de telle façon qu'un codage de temps de propagation, de phase, d'amplitude ou de forme d'impulsion peut s'effectuer.

Figur 1

# Figur 2a

Laufzeit der Antwortsignale

EP 0 815 469 B1

# Figur 2b

Laufzeit der Antwortsignale

EP 0 815 469 B1

Figur 3

# Figur 4

# Figur 5

29.1 }

29.2 }

29.3 }

29.4 }

31.1

31.2

31.3

Initial Delay

30.1

30.2

30.3

30.4

28

EP 0 815 469 B1

# Figur 6

# Figur 7